# EUROPEAN PATENT APPLICATION

(11) **EP 3 836 205 A1**
(43) Date of publication of application: **16.06.2021**
(21) Application number: 19216157.8
(22) Date of filing: 13.12.2019
(51) Int. Cl.: H01L 23/473

(54) **COOLING DEVICE FOR SEMICONDUCTOR SWITCHING ELEMENTS, POWER INVERTER DEVICE, ARRANGEMENT AND MANUFACTURING METHOD**

(71) Applicant: Valeo Siemens eAutomotive Germany GmbH, 91056 Erlangen (DE)
(72) Inventor: HUCK, Fabian, 90425 Nürnberg (DE); RAYYA, Monzer, 90431 Nürnberg (DE); TRODLER, Dirk, 91227 Leinburg (DE)
(74) Representative: Dr. Gassner & Partner mbB

(57) **Abstract**

Cooling device (15) for semiconductor switching elements (10, 11), comprising a cooling channel (16) that allows a coolant to flow through the cooling channel (16) along a main flow direction (17), and a guiding device (18) that is arranged inside the cooling channel (16) and comprises:
- a sheet (19) extending along the main flow direction (17) and
- a plurality of guiding elements (21, 22) that extend from the sheet (19) and enclose a non-zero angle with the sheet (19).

## Description

The present invention relates to a cooling device for semiconductor switching elements, comprising a cooling channel that allows a coolant to flow through the cooling channel along a main flow direction.

Besides, the present invention relates to a power inverter device, an arrangement with a power inverter device and with an electric machine and a method for manufacturing a power inverter device.

When operating semiconductor switching elements, exemplarily within a power inverter device that supplies an electric machine of an electric driven vehicle, significant power losses are generated that may cause overtemperature failures of the semiconductor switching elements. It is known to use a cooling device for cooling the semiconductor switching elements that has a cooling channel in order to allow a coolant to flow along the semiconductor switching elements for cooling them. Having a flat heat exchange interface between the coolant and switching elements results in a rather poor heat transfer but low costs.

In order to improve the heat, transfer it has been proposed to use additional heat sink structures, e.g. pin fins, that extend into the cooling channel for enlarging the heat exchange interface and for generating turbulences within the coolant. Exemplarily, the document US 2004/0150956 A1 discloses a heat sink assembly used in power electronics applications for transferring heat from a heat generating source, that comprises a semiconductor die, to a cooling medium, comprising a baseplate and a plurality of thermally conductive pins located inside the baseplate for transferring heat from the heat generating source to the cooling medium. A further possibility is the usage of ribbon bonds extending into the cooling channel.

However, pin fins render the cooling device expensive, whereas ribbon bonds are usually cheaper than pin fins but have a reduced cooling efficiency. A further aspect of cooling devices is the interdependence between cooling efficiency and pressure drop caused by additional heat sink structures. Therein, a higher cooling efficiency results in a higher pressure drop. Typically, pin fins as well as ribbon bonds need be redesigned completely, when it is desired to change the cooling efficiency or the pressure drop, respectively, in a present design.

Therefore, it is an object of the present invention to provide an improved possibility for cooling semiconductor switching elements with respect to a usage in a power inverter device, particularly for driving a vehicle.

According to the present invention the above object is solved by a cooling device as initially described, further comprising a guiding device that is arranged inside the cooling channel and comprises: a sheet extending along the main flow direction and a plurality of guiding elements that extend from the sheet and enclose an non-zero angle with the sheet.

By providing the guiding device within the cooling channel turbulences within the coolant are generated that allow a higher heat dissipation from the semiconductor switching elements. Thereby, a cooling effect similar to conventional pin fins and ribbon bonds is achieved without the need for such expensive heat sink structures. Furthermore, the guiding elements can be flexibly bent to the non-zero angle, therein allowing to adjust a cooling efficiency and a corresponding pressure drop caused by the guiding device to a desired degree. Thus, the cooling device according to the present invention provides a cheap and easily adjustable possibility for cooling the semiconductor switching elements. Particularly, by changing the angle the guiding device can be adjusted to cooling requirements and pressure drop constraints according to specific individual project specifications.

Typically, the guiding elements are flat. They may have a rectangular shape. Preferably, the guiding elements are formed integrally with the sheet.

With respect to the cooling device according to the invention it is preferred that the guiding elements are bent out of the sheet. This allows cheap manufacturing of the guiding device by deep-drawing and/or bending. Therein, the non-zero angle of the guiding elements may refer to a bending angle with respect to the sheet.

Alternatively, it is possible that that the guiding elements are attached to the sheet, e.g. by gluing or welding.

It is preferred that an absolute value of the angle of at least a part of the plurality of guiding elements is larger than 10 degrees, particularly larger than 25 degrees, and smaller than 80 degrees, particularly smaller than 65 degrees. Alternatively or additionally, an absolute value of the angle of at least a part of the plurality of guiding elements is larger than 100 degrees, particularly larger than 115 degrees, and smaller than 170 degrees, particularly smaller than 155 degrees. It is possible that that the absolute angle of all guiding elements is larger than 10 degrees, particularly larger than 25 degrees, and smaller than 80 degrees, particularly smaller than 65 degrees, or, alternatively, larger than 100 degrees, particularly larger than 115 degrees, and smaller than 170 degrees, particularly smaller than 155 degrees.

Preferably, multiple of the guiding elements are arranged in multiple rows being perpendicular to the main flow direction. Therein, the guiding elements may be arranged in a rectangular pattern or guiding elements of adjacent rows may be shifted to each other.

Advantageously, the guiding device is made of plastic or metal.

The cooling device according to the invention typically further comprises a carrier for the semiconductor switching elements. The carrier may be a base plate.

Preferably, the carrier and the guiding device are separate components of the cooling device.

Preferably, at least a part of the plurality of guiding elements is formed on a side of the sheet facing the carrier. Thereby, the guiding elements steer the coolant towards the carrier and increase the cooling effect. Alternatively or additionally, at least a part of the plurality of guiding elements is formed on a side of the sheet opposite of the carrier. These guiding elements allow to adjust a distance between the sheet and a bottom of the cooling channel.

Advantageously, a cooling-channel side of the carrier that forms a boundary of the cooling channel is flat. Such a flat carrier can be manufactured with very low effort in comparison to carriers having pin fins or ribbon bonds.

The cooling device according to the invention may comprise an inlet for supplying the coolant to the cooling channel and an outlet for draining the coolant out of the cooling channel. The main flowing direction may be a direction from the inlet to the outlet.

Typically, the guiding elements extend from the sheet into the direction of the outlet.

According to a specific embodiment distances between guiding elements that are adjacent to each other with respect to the main flow direction are larger on an inlet-side of the cooling channel than distances between guiding elements that are adjacent to each other with respect to the main flow direction on an outlet-side of the cooling channel. Therein, it is considered that the cooling efficiency depends on a local heat transfer coefficient between the coolant and the carrier as well as on a temperature difference between the coolant and the carrier. As the coolant travels through the cooling channel, it heats up, therein, reducing the temperature difference to the carrier and reducing the cooling efficiency. By reducing the distances between adjacent guiding elements in a direction from the inlet-side to the outlet-side of the cooling channel, the local heat transfer coefficient is improved because of increased turbulence. This effect of increasing the local heat transfer coefficient compensated the effect of the fluid heating up along the direction from the inlet-side to the outlet-side of the cooling channel. This way, a more balanced temperature distributing within the carrier and, thus, the plurality of semiconductor switching elements can be achieved.

Preferably, the cooling channel is formed by cavity formed within a housing element. Therein, the carrier may close the cavity.

Advantageously, the guiding device is disposed on a bottom of the cooling channel. The bottom may be formed by the cavity.

According to the invention the above object is furthermore solved by a power inverter device, comprising a plurality of semiconductor switching elements and a cooling device for the semiconductor switching elements according to the invention.

According to the invention the above object is furthermore solved by an arrangement with a power inverter device according to the invention and an electric machine being suitable to drive a vehicle, wherein the power inverter device is configured to supply the electric machine.

According to the invention the above object is furthermore solved by a method for manufacturing a cooling device for semiconductor switching elements according the invention, wherein the guiding elements are formed by deep-drawing and/or bending the sheet. All statements referring to the inventive cooling device, the inventive power converter and the inventive arrangement apply analogously to the inventive method so that the above-mentioned advantages may be achieved by the method as well.

Further details and advantages of the invention are disclosed in the following, wherein reference is made to the schematic drawings, which show:
- Fig. 1: a block diagram of an embodiment of an arrangement according to the invention with a first embodiment of a power inverter device according to the invention having a first embodiment of the cooling device according to the invention;
- Fig. 2: a longitudinal section of the first embodiment of the power inverter device;
- Fig. 3: a cross-section of the first embodiment of the power inverter device along a plane III-III in Fig. 2; and
- Fig. 4: a longitudinal section of a second embodiment of the power inverter device according to the invention having a second embodiment of the cooling device according to the invention.

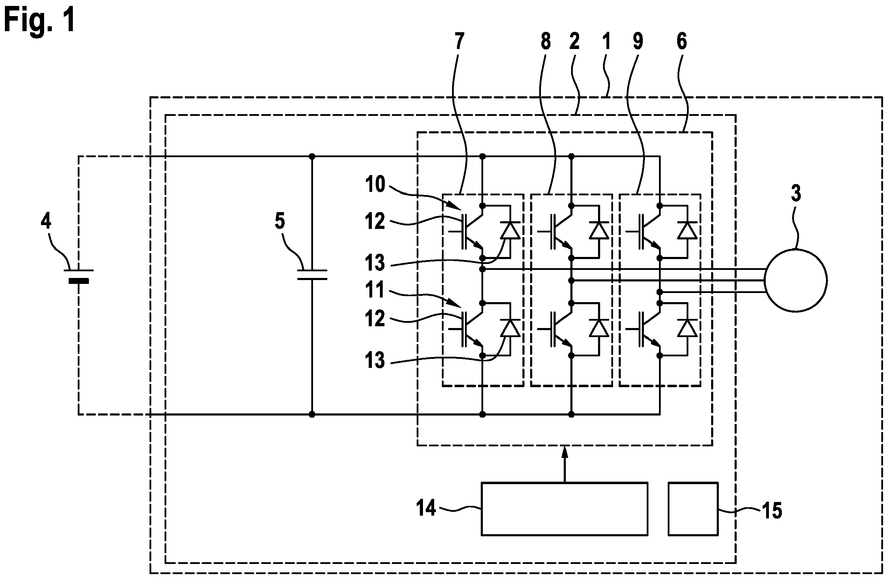

Fig. 1 is a block diagram of an embodiment of an arrangement 1 with a power inverter device 2 and an electric machine 3, wherein the power inverter device 2 is configured to supply the electric machine 3. The electric machine 3 is suitable for driving a vehicle such as a battery electric vehicle or a hybrid electric vehicle. Furthermore, Fig. 1 shows a high-voltage battery 4 connected to a DC link of the power inverter device 2 or to the arrangement 1, respectively.

The power inverter device 2 comprises a DC link capacitor 5, and a semiconductor switching element module 6 having a first semiconductor switching element arrangement 7, a second semiconductor switching element arrangement 8 and a third semiconductor switching element arrangement 9. Each semiconductor switching element arrangement 7, 8, 9 is configured to provide an output phase current of the power inverter device 2. Thereto, each semiconductor switching element arrangement 7, 8, 9 comprises a half-bridge formed by two semiconductor switching elements 10, 11. Each semiconductor switching element 10, 11 has a transistor structure 12 and an antiparallel diode structure 13. The transistor structure 12 and the diode structure 13 may be formed by one or multiple Power-MOSFETs or by one or multiple connections of an IGBT and a diode.

Furthermore, the power inverter device 2 comprises a control unit 14 being configured to control the semiconductor switching element module 6 or the semiconductor switching element arrangements 7, 8, 9, respectively, so as to provide a three-phase output voltage. The power inverter device 2 further comprises a first embodiment of a cooling device 15 for cooling the semiconductor switching elements 10, 11.

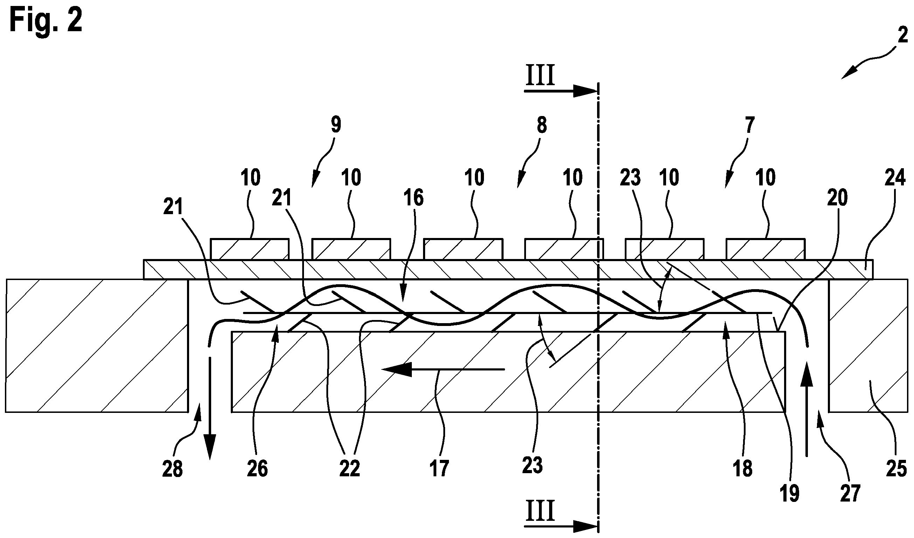

Fig. 2 is a longitudinal section of the first embodiment of the power inverter device 2.

The cooling device 15 comprises a cooling channel 16, which allows a coolant to flow through the therethrough along a main flow direction 17, and a guiding device 18 being arranged inside the cooling channel 16.

The guiding device 18 comprises a sheet 19 extending along the main flow direction 17 in parallel to a bottom 20 of the cooling channel 16 and a plurality of guiding elements 21, 22 that extend from the sheet 19 and enclose a non-zero angle 23 with the sheet 19. The guiding elements 21, 22 are bent out of the sheet 19, wherein an absolute value of the angle 23 is exemplarily chosen to 45 degrees. I.e. each guiding elements 21, 22 overlaps an opening in the sheet resulting from bending. The guiding elements 21, 22 generate turbulences that superpose the main flow direction 17 and provide an additional cooling effect in comparison to a conventional cooling device without guiding device.

Besides, the cooling device 15 comprises a base plate forming a flat carrier 24, on which the semiconductor switching elements 10, 11 are mounted, and a housing element 25 having a cavity 26 formed therein. The cavity 26 forms the cooling channel 16, which is closed by the carrier 24. Furthermore, the cooling device 15 comprises an inlet 27 for suppling the coolant to the cooling channel 16 and an outlet 28 for draining the coolant out of the cooling channel 16.

The guiding elements 21 are formed on a side of the sheet 19 facing the carrier 24 and the guiding elements 22 are formed on the opposite side or bottom-side, respectively, of the sheet 19. All guiding elements extend from the sheet 19 into the direction of the outlet 28. Therein, the guiding elements 21 add a vertical velocity component locally of the main flow direction to the coolant for steering the cooling towards the carrier 24. This provides an additional cooling effect. The guiding elements 22 lie upon the bottom 20 for defining a desired distance between the sheet 19 and the bottom 20.

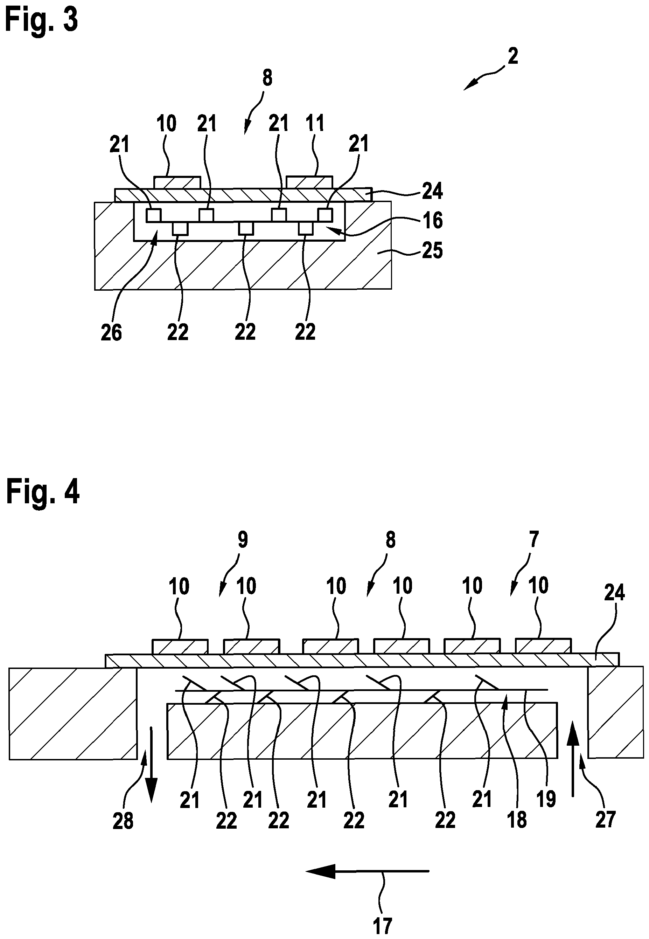

Fig. 3 is a cross-sectional view of the power inverter device 2 along a plane III-III in Fig. 2.

As can be seen in conjunction of Fig. 2 and Fig. 3 the guiding elements 21 facing the carrier 24 are arranged in a plurality of rows, exemplarily six rows, each having multiple, exemplarily four, guiding elements 21. The guiding elements 22 facing the bottom 20 are arranged in a plurality of rows, exemplarily five rows, each having multiple, exemplarily three, guiding elements 22. Therein, positions of the guiding elements 21 in each row are shifted with respect to position of the guiding elements 22.

Fig. 4 is a longitudinal section of a second embodiment a power inverter device 2 having a second embodiment of a cooling device 15. All statements to the first embodiment apply analogously to the second embodiments and differences thereto are described in the following. Therein, identical reference signs are assigned to identical or equivalent components.

According to the second embodiment distances between guiding elements 21, 22 that are adjacent to each other with respect to the main flow direction 17 are larger on an inlet-side of the cooling channel 16 than distances between guiding elements 21, 22 that are adjacent to each other with respect to the main flow direction 17 on an outlet-side of the cooling channel 16. By subsequently flowing below the semiconductor switching element arrangements 7, 8, 9, the coolant is more and more heated up along the main flow direction. As the cooling effect caused by the turbulences and by steering the coolant towards the carrier 24 is significantly higher on the inlet-side than on the outlet-side because of decreasing distances between adjacent guiding elements 21, 22, a more balanced temperature distribution along the cooling channel 16 is achieved.

In both embodiments described afore, all or some of the guiding elements 21, 22 may be bent by an obtuse angle of e.g. 135 degrees. Therein, the guiding elements 21, 22 overlap sections of the sheet 19 instead of the openings.

## Claims

1. Cooling device (15) for semiconductor switching elements (10, 11), comprising a cooling channel (16) that allows a coolant to flow through the cooling channel (16) along a main flow direction (17),
**characterized by**
a guiding device (18) that is arranged inside the cooling channel (16) and
com prises:
- a sheet (19) extending along the main flow direction (17) and
- a plurality of guiding elements (21, 22) that extend from the sheet (19) and enclose a non-zero angle with the sheet (19).

2. Cooling device according to any of the preceding claims, wherein
the guiding elements (21, 22) are bent out of the sheet (19).

3. Cooling device according to claim 1 or 2, wherein
an absolute value of the angle (23) of at least a part of the plurality of guiding elements (21, 22) is larger than 10 degrees and smaller than 80 degrees and/or an absolute value of the angle (23) of at least a part of the plurality of guiding elements (21, 22) is larger than 100 degrees and smaller than 170 degrees.

4. Cooling device according to any of the preceding claims, wherein
multiple of the guiding elements (21, 22) are arranged in multiple rows being perpendicular to the main flow direction (17).

5. Cooling device according to any of the preceding claims, further comprising a carrier (24) for the semiconductor switching elements (10, 11).

6. Cooling device according to claim 5, wherein
at least a part of the plurality of guiding elements (21) is formed on a side of the sheet (19) facing the carrier (24) and/or at least a part of the plurality of guiding elements (22) is formed on a side of the sheet opposite of the carrier (24).

7. Cooling device according to claim 5 or 6, wherein
a cooling-channel side of the carrier (24) that forms a boundary of the cooling channel (16) is flat.

8. Cooling device according to any of the preceding claims, further comprising an inlet (27) for supplying the coolant to the cooling channel (16) and an outlet (28) for draining the coolant out of the cooling channel (16).

9. Cooling device according to claim 8, wherein
the guiding elements (21, 22) extend from the sheet into the direction of the outlet (28).

10. Cooling device according to claim 8 or 9, wherein
distances between guiding elements (21, 22) that are adjacent to each other with respect to the main flow direction (17) are larger on an inlet-side of the cooling channel (16) than distances between guiding elements (21, 22) that are adjacent to each other with respect to the main flow direction (17) on an outlet-side of the cooling channel (16).

11. Cooling device according to any of the preceding claims, wherein
the cooling channel (16) is formed by cavity (26) formed within a housing element (25).

12. Cooling device according to any preceding clams,
wherein the guiding device (18) is disposed on a bottom (20) of the cooling channel (16).

13. Power inverter device (2), comprising a plurality of semiconductor switching elements (10, 11) and a cooling device (15) for the semiconductor switching elements (10, 11) according to any of the preceding claims.

14. Arrangement (1) with a power inverter device (2) according to claim 13 and an electric machine (3) being suitable to drive a vehicle, wherein the power inverter device (2) is configured to supply the electric machine (3).

15. Method for manufacturing a cooling device (15) for semiconductor switching elements (10, 11) according to any of claims 1 to 12, wherein the guiding elements (21, 22) are formed by deep-drawing and/or bending the sheet (19).
